# FASCICULE DE BREVET EUROPEEN

(11) **EP 3 743 942 B1**
(45) Date de publication et mention de la délivrance du brevet: **16.02.2022**
(21) Numéro de dépôt: 19710006.8
(22) Date de dépôt: 23.01.2019
(51) Int. Cl.: H01L 23/00, H01L 23/528, H01L 21/48, H01L 23/48

(54) **PUCE ELECTRONIQUE A FACE ARRIERE PROTEGEE PAR UNE STRUCTURE DE FRAGILISATION AMELIOREE**
ELEKTRONISCHER CHIP, DESSEN RÜCKSEITE DURCH EINE VERBESSERTE VERSPRÖDUNGSSTRUKTUR GESCHÜTZT IST
ELECTRONIC CHIP, THE REAR FACE OF WHICH IS PROTECTED BY AN IMPROVED EMBRITTLEMENT STRUCTURE

(30) Priorité: 25.01.2018 FR 1850603
(43) Date de publication de la demande: 02.12.2020
(73) Titulaire: Commissariat à l'énergie atomique et aux énergies alternatives, 75015 Paris (FR)
(72) Inventeur: BOREL, Stephan, 38920 CROLLES (FR); DUPERREX, Lucas, 38000 GRENOBLE (FR)
(74) Mandataire: Brevalex
(86) Numéro de dépôt international: PCT/FR2019/050149
(87) Numéro de publication internationale: WO 2019/145640

(56) Documents cités:
- EP-A1- 1 127 387
- EP-A1- 2 866 259

## Description

### DOMAINE TECHNIQUE ET ART ANTÉRIEUR

L'invention concerne la protection des puces électroniques, et porte sur une puce électronique comportant notamment des moyens protégeant la face arrière de la puce électronique et permettant d'empêcher l'accès au circuit électronique de la puce depuis sa face arrière. L'invention s'applique à tout type de puce électronique : puce de téléphonie mobile, de carte bancaire, de carte santé, de document d'identité, etc.

Les attaques que peut subir une puce électronique ont généralement pour but d'accéder à des données confidentielles stockées dans le circuit électronique de la puce afin de la cloner, de modifier les informations stockées, d'usurper l'identité de son possesseur, etc. Une puce électronique peut être attaquée de multiples manières : chimique, physique, laser, électromagnétique, électrique, logicielle, etc.

Sur une puce électronique dite « sécurisée », la face avant, c'est-à-dire la face de la puce du côté de laquelle se trouve le circuit électronique, est généralement protégée par de multiples moyens.

Les éléments de protection de la face avant de la puce peuvent servir à empêcher l'accès aux zones sensibles du circuit électronique. Par exemple, une couche métallique disposée au niveau de la face avant de la puce peut former un écran opaque aux rayons infrarouges et empêcher ainsi les attaques par injection de fautes réalisées à l'aide d'un laser infrarouge. En outre, une piste métallique disposée au niveau de la face avant de la puce électronique peut servir à empêcher un attaquant de poser des pointes de test sur des zones de transit ou de stockage d'informations sensibles afin d'en lire le contenu.

Les éléments de protection de la face avant de la puce peuvent également servir à détecter et renseigner le circuit électronique de la puce d'une attaque ou d'une tentative d'attaque afin de déclencher une réaction permettant de protéger les données convoitées. Par exemple, une photodiode peut permettre, par une mesure d'intensité lumineuse, de déceler l'utilisation d'un laser à des fins d'injection de fautes dans le circuit électronique de la puce.

Par contre, la face arrière de la puce électronique est généralement moins bien protégée et constitue donc une voie d'accès privilégiée à la face avant. Sans moyens de protection de cette face arrière, rien ne s'oppose à la mise en œuvre d'un amincissement du substrat de la puce depuis sa face arrière, ou à la réalisation de défaillances électroniques au laser infrarouge (« glitch »), le silicium (qui est le matériau généralement utilisé) du substrat étant transparent aux longueurs d'onde caractéristiques de l'infrarouge. L'accès au circuit électronique de la puce obtenu permet ensuite de réaliser par exemple une lecture des données via l'obtention de la clé de chiffrement utilisée dans le circuit.

Pour protéger la face arrière d'une puce, il est possible par exemple de réaliser un réflecteur sur la face arrière qui, couplé à un émetteur/récepteur disposé en face avant, permet de vérifier l'intégrité de la face arrière car en cas d'attaque par amincissement, ce réflecteur est alors altéré. Il est également possible de réaliser un condensateur 3D permettant, par mesure de capacité avec le substrat, de déceler un amincissement de la puce par sa face arrière.

Le document EP 2 866 259 A1 divulgue une puce électronique comportant un circuit électronique disposé du côté d'une face avant d'un substrat et une structure de fragilisation comprenant des trous borgnes.

Le document EP 1 127 387 A1 divulgue la réalisation de vias électriquement conducteurs dans un circuit imprimé comportant des sections de forme non-circulaire.

Le document EP 3 086 368 A2 propose une solution de protection de la face arrière d'une puce basée sur plusieurs éléments:
- une structure de fragilisation formée de trous borgnes permettant de fragiliser la puce en cas d'amincissement de celle-ci depuis sa face arrière et, lorsque les parois des trous borgnes sont recouvertes par un film métallique, de former un écran de protection en 3D ;
- un élément résistif formant un serpentin métallique couvrant la face arrière de la puce et dont l'intégrité peut être vérifiée par la mesure de sa résistance ;
- une encapsulation par un polymère opaque aux infrarouges, résistant au FIB (sonde ionique focalisée) et plus résistant aux agents de gravure chimique (HNO₃ notamment) que le polymère disposé sous le serpentin métallique.

Les trous borgnes et les vias électriquement conducteurs, ou TSV ("Through Silicon Via") qui relient électriquement l'élément résistif (en face arrière) au circuit électronique (en face avant) sont réalisés au cours d'une même étape de gravure pour des raisons de coût. Une différence de profondeur entre les vias électriquement conducteurs et les trous borgnes est obtenue en utilisant le phénomène d'ARDE ("Aspect Ratio Dépendant Etching") selon lequel une profondeur de gravure plus importante est obtenue pour les motifs de plus grande largeur au cours d'une seule étape de gravure. Les vias électriquement conducteurs doivent donc être réalisés avec une section, dans le plan de la face arrière du substrat, de plus grandes dimensions que celle des trous borgnes.

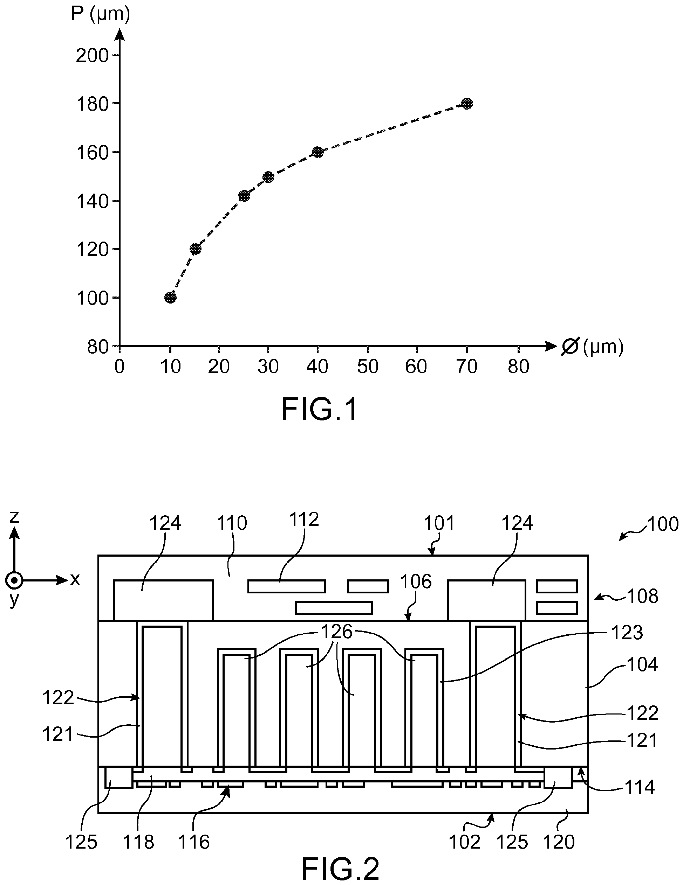

Les trous borgnes peuvent comporter des diamètres différents afin qu'ils aient des profondeurs différentes. En effet, selon le phénomène d'ARDE, un trou réalisé avec une section circulaire de rayon R présente une surface d'ouverture S telle que S = π.R² et permet d'obtenir, pour une durée de gravure donnée, une profondeur de gravure P telle que définie par la courbe P = f(∅) représentée sur la figure 1, avec ∅ correspondant au diamètre de la section circulaire du trou réalisé.

Dans une structure, les fractures s'initient là où les contraintes se concentrent. Or, dans la structure de fragilisation décrite ci-dessus, les zones de contraintes maximales sont localisées au niveau des trous borgnes de plus petit diamètre. Lorsque la puce électronique comporte la structure de fragilisation et qu'elle est soumise à des contraintes en flexion, des fissures apparaissent précisément au niveau des zones où se trouvent les contraintes maximales, à savoir les trous borgnes de plus petit diamètre formés dans la structure de fragilisation. Ce sont donc les trous borgnes réalisés avec les plus petits diamètres qui contribuent le plus au caractère fragilisant de la structure de fragilisation. Mais lors d'une attaque par amincissement depuis la face arrière de la puce électronique, par exemple par micro-fraisage, ce sont également les trous borgnes avec les plus petit diamètres, et donc avec les plus faibles profondeurs, qui sont supprimés en premier, n'apportant plus d'effet fragilisant à la structure de fragilisation. Les trous borgnes de plus grands diamètres, et donc de plus grandes profondeurs, restent présents dans le substrat, même après un fort amincissement, mais apportent un moindre effet fragilisant à la structure.

### EXPOSÉ DE L'INVENTION

Un but de la présente invention est de proposer une puce électronique comprenant une face arrière protégée par une structure de fragilisation qui ne présente pas les inconvénients de l'art antérieur, c'est-à-dire apportant une importante fragilisation et dont les éléments apportant cette fragilisation ne soient pas facilement supprimables.

Pour cela, l'invention propose une puce électronique selon la revendication 1.

Cette puce électronique comporte donc une structure de fragilisation incluant des trous borgnes dont le motif, pour chaque trou borgne, peut comprendre au moins un faible rayon de courbure par rapport à celui d'un cercle de surface égale à la surface de la section du trou borgne. Ainsi, par rapport à un trou borgne de section circulaire qui comporte, dans un plan parallèle à la face arrière du substrat, une surface S' = π.R² dont la valeur dépend uniquement de la valeur du rayon de courbure, les trous borgnes de cette structure de fragilisation sont réalisés avec, dans un plan parallèle à la face arrière du substrat, des motifs tels que la valeur de la surface de ces motifs ne dépende pas uniquement de la valeur du rayon de courbure. En choisissant une forme remplissant la condition S > π.R², il est possible de réaliser des trous borgnes qui, par rapport à un trou borgne de section de forme circulaire avec un rayon de courbure R équivalent, atteignent une profondeur plus importante dans le substrat en raison du phénomène d'ARDE se produisant lors de la réalisation des trous borgnes.

Il est donc possible de choisir les valeurs du rayon de courbure, dont dépend le caractère fragilisant de la structure de fragilisation, et de la surface, et donc implicitement de la profondeur atteinte, dont dépend la facilité à éliminer les trous borgnes, indépendamment l'une de l'autre. Les trous borgnes peuvent donc être réalisés avec une section qui présente, dans un plan parallèle à la face arrière du substrat, une surface S importante pour atteindre une profondeur importante dans le substrat et un faible rayon de courbure R pour former des zones de concentration de contraintes et ainsi obtenir une structure de fragilisation ayant un fort pouvoir de fragilisation.

Du fait que la forme inclut un contour extérieur fermé dont la forme inclut au moins un rayon de courbure R tel que S > π.R², il est possible d'ajuster la valeur du rayon de courbure en fonction du niveau de fragilisation recherché, c'est-à-dire ni trop fragile pour ne pas risquer de briser la structure de fragilisation lors de la réalisation de la puce électronique, ni trop peu fragile pour avoir une bonne protection de la face arrière.

En outre, cette configuration de la structure de fragilisation ne modifie pas sa fonction première, à savoir former une protection vis-à-vis d'un amincissement mécanique ou d'un polissage de la puce électronique depuis sa face arrière, ainsi que vis-à-vis d'une attaque par FIB ou par gravure chimique de la face arrière de la puce électronique.

De manière avantageuse, la forme de la section de chacun des trous borgnes, ou la forme du contour extérieur fermé de la section de chacun des trous borgnes, peut être telle que la valeur du rapport S/(π.R²) est supérieure ou égale à environ 50, ou comprise entre environ 20 et 100, ou bien comprise entre environ 50 et 100, ou bien supérieure ou égale à 20. En choisissant les valeurs des paramètres S et R telles que S/(π.R²) > 20, on obtient une configuration très avantageuse combinant un fort pouvoir de fragilisation des trous borgnes (en raison du faible rayon de courbure R présent dans le motif des contours des trous borgnes) et une forte résistance aux attaques par amincissement (en raison de la grande surface S des sections des trous borgnes et donc de la profondeur importante atteinte par les trous bornes).

La section de chacun des trous borgnes, ou le contour extérieur fermé de la section de chacun des trous borgnes, dans le plan parallèle à la face arrière du substrat, peut être de forme sensiblement polygonale (et avantageusement carrée ou rectangulaire) avec des coins arrondis de rayons de courbure de valeur R, et/ou peut être en forme de croix comprenant des extrémités et/ou des jonctions de branches de la croix qui sont arrondies et qui présentent des rayons de courbure de valeur R.

Les trous borgnes peuvent être tels que les surfaces des sections desdits trous borgnes soient différentes les unes des autres et que les rayons de courbure inclus dans les formes des sections desdits trous borgnes, ou dans les formes des contours extérieurs fermés des sections desdits trous borgnes, soient sensiblement similaires les uns des autres. Dans cette configuration, des trous borgnes de différentes profondeurs sont obtenus dans le substrat en variant les dimensions des sections des trous borgnes, tout en conservant un fort pouvoir de fragilisation pour chacun de ces trous borgnes.

Des parois intérieures des trous borgnes peuvent être recouvertes d'une couche électriquement conductrice.

La puce électronique peut comporter en outre :
- au moins un élément résistif disposé du côté de la face arrière du substrat et à l'aplomb d'au moins une partie du circuit électronique ;
- au moins deux vias électriquement conducteurs traversant le substrat et s'étendant entre les faces avant et arrière du substrat, chacun relié électriquement au circuit électronique et à l'une des extrémités de l'élément résistif tel que la valeur de la résistance électrique de l'élément résistif puisse être mesurée par le circuit électronique.

Grâce à la présence de l'élément résistif en face arrière de la puce électronique, si un amincissement mécanique ou un polissage de la face arrière de la puce électronique est mis en œuvre, cet amincissement ou ce polissage provoque l'altération de l'élément résistif. Cette altération de l'élément résistif est alors détectée par le circuit électronique de la puce qui peut, par exemple, se mettre en défaut.

L'élément résistif peut comporter au moins une piste électriquement conductrice ayant au moins un motif de serpentin et/ou plusieurs motifs alternés, entremêlés, enroulés ou entrelacés. Une telle forme complexe de l'élément résistif peut en outre contribuer à empêcher une attaque consistant à remplacer l'élément résistif par une résistance électrique équivalente afin d'accéder au circuit électronique depuis la face arrière de la puce électronique.

La ou les pistes conductrices de l'élément résistif peuvent avoir une largeur comprise entre environ 1 µm et 20 µm, et/ou des portions de la ou d'une des pistes conductrices qui sont voisines et parallèles peuvent être espacées l'une de l'autre d'une distance comprise entre environ 1 µm et 20 µm. Une telle configuration de l'élément résistif laisse ainsi trop peu d'espace pour une attaque par un faisceau FIB sans que cela engendre une modification importante de la valeur de la résistance électrique de l'élément résistif.

L'invention concerne également un procédé de réalisation d'une puce électronique selon la revendication 8.

Le procédé peut comporter en outre la réalisation d'un élément résistif disposé du côté de la face arrière du substrat et à l'aplomb d'au moins une partie du circuit électronique, et d'au moins deux vias électriquement conducteurs traversant le substrat et s'étendant entre les faces avant et arrière du substrat, chacun relié électriquement au circuit électronique et à l'une des extrémités de l'élément résistif tel que la valeur de la résistance électrique de l'élément résistif puisse être mesurée par le circuit électronique.

La réalisation des vias électriquement conducteurs et des trous borgnes peut comporter au moins la mise en œuvre des étapes suivantes :
- réalisation d'un masque de gravure sur la face arrière du substrat, dont le motif définit les sections, dans le plan parallèle à la face arrière du substrat, des vias électriquement conducteurs et des trous borgnes ;
- gravure à travers la face arrière du substrat selon le motif du masque de gravure.

Pour la réalisation des vias électriquement conducteurs, d'autres étapes telles qu'une isolation et une métallisation peuvent être mises en œuvre.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente une courbe donnant, pour une durée de gravure donnée, la profondeur de gravure obtenue en fonction du diamètre du trou gravé dans du semi-conducteur ;
- la figure 2 représente schématiquement une vue en coupe d'une puce électronique, objet de la présente invention, selon un mode de réalisation particulier ;
- la figure 3 représente plusieurs exemples de réalisation de trous borgnes d'une structure de fragilisation d'une puce électronique, objet de la présente invention ;
- la figure 4 représente un exemple de réalisation d'un trou borgne d'une structure de fragilisation d'une puce électronique, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

On se réfère tout d'abord à la figure 2 qui représente schématiquement une vue en coupe d'une puce électronique 100 comportant une face avant 101 et une face arrière 102 protégée, selon un mode de réalisation particulier.

La puce électronique 100 est réalisée à partir d'un substrat 104. Le substrat 104 comprend par exemple un matériau semi-conducteur tel que du silicium. L'épaisseur du substrat 104 est par exemple égale à environ 180 µm lorsque la puce électronique 100 est destinée à être disposée dans une carte à puce. D'autres types de substrat peuvent être utilisés pour la réalisation de la puce électronique 100, en fonction de l'utilisation finale de la puce électronique 100.

Le substrat 104 comporte une face avant 106 sur laquelle est réalisé un circuit électronique 108. Le circuit électronique 108 comporte un empilement de couches 110 (diélectriques, métalliques, semi-conductrices) formant notamment une partie active incluant des composants électroniques 112 (transistors, mémoires, etc.) et destinée à être protégée lors d'éventuelles attaques de la puce électronique 100. Bien que non décrits ici, la puce électronique 100 peut comporter des moyens protégeant le circuit électronique 108 depuis la face avant 101.

Le substrat 104 comporte également une face arrière 114 au niveau de laquelle sont réalisés des moyens de protection de cette face arrière 114 de la puce électronique 100.

L'un de ces moyens de protection est un élément résistif 116. Cet élément résistif 116 est disposé à l'aplomb d'au moins une partie du circuit électronique 108, et avantageusement à l'aplomb de toute la partie active de ce circuit, du côté de la face arrière 114 du substrat 104.

Cet élément résistif 116 est formé d'une ou plusieurs pistes électriquement conductrices disposées sur une couche diélectrique 118 qui recouvre la face arrière 114 du substrat 104. La couche diélectrique 118 comporte par exemple du SiO₂ et/ou du SiN, par exemple déposé par PECVD (dépôt chimique en phase vapeur assisté par plasma) et d'épaisseur comprise entre environ 1 µm et 10 µm. La couche diélectrique 118 peut également comporter au moins un matériau polymère et être déposée par centrifugation ou par laminage. L'élément résistif 116 est par exemple formé par un dépôt ECD (dépôt électrochimique) ou PVD (dépôt physique en phase vapeur) de cuivre et/ou d'aluminium et d'épaisseur par exemple comprise entre environ 1 µm et 20 µm, et avantageusement comprise entre environ 1 µm et 10 µm.

L'élément résistif 116 et les parties de la couche diélectrique 118 non recouvertes par l'élément résistif 116 sont recouverts par une couche de protection 120 formant la face arrière 102 de la puce électronique 100. Cette couche de protection 120 comporte par exemple un polymère opaque et sert notamment de protection vis-à-vis des attaques optiques, chimiques ou encore par FIB.

L'élément résistif 116 est ici réalisé sous la forme d'un serpentin. La ou les pistes électriquement conductrices de l'élément résistif 116 peuvent avoir au moins un motif de serpentin et/ou plusieurs motifs alternés, entremêlés, enroulés ou entrelacés, afin de rendre difficilement appréhendable l'élément résistif 116, et notamment de rendre difficilement identifiable l'emplacement des deux extrémités de l'élément résistif 116, dans le cas d'une tentative d'attaque de la puce électronique 100 depuis sa face arrière 102.

Les extrémités de l'élément résistif 116 (au nombre de deux dans cet exemple de réalisation) sont chacune reliées électriquement au circuit électronique 108 par l'intermédiaire d'un via électriquement conducteur, ou TSV, 122 qui traverse toute l'épaisseur du substrat 104 et débouche sur des plots de contact 124 du circuit électronique 108, ainsi que par l'intermédiaire d'interconnexions électriques 125 formées à travers la couche diélectrique 118. Les vias électriquement conducteurs 122 sont remplis au moins partiellement par un matériau électriquement conducteur assurant la connexion électrique entre les extrémités de l'élément résistif 116 et les plots de contact 124 du circuit électronique 108. Une couche de matériau électriquement conducteur 121 peut notamment recouvrir les parois latérales et les parois de fond des vias électriquement conducteurs 122, le reste du volume des vias électriquement conducteurs 122 pouvant être rempli par un matériau diélectrique, par exemple celui servant également à former la couche diélectrique 118, ou bien rester vide.

Lors du fonctionnement de la puce électronique 100, la valeur de la résistance électrique de l'élément résistif 116 est mesurée entre ses extrémités par le circuit électronique 108. Si la puce électronique 100 est attaquée depuis sa face arrière 102 et que cette attaque détériore l'élément résistif 116, la valeur de la résistance électrique mesurée par le circuit électronique 108 change et celui-ci peut alors prendre des mesures appropriées pour traiter cette attaque.

Un autre moyen de protection de la face arrière 102 de la puce électronique 100 est une structure de fragilisation comprenant des trous borgnes 126 qui, contrairement aux premiers vias 122, ne traversent pas toute l'épaisseur du substrat 104. Les trous borgnes 126 traversent la face arrière 114 du substrat 104 et une partie seulement de l'épaisseur du substrat 104. La profondeur de matériau du substrat 104 traversée par les trous borgnes 126 n'est pas similaire à celle traversée par les vias électriquement conducteurs 122.

Les trous borgnes 126 comportent chacun une section, dans un plan parallèle à la face arrière 114 du substrat 104, dont la forme inclut un contour extérieur fermé dont la forme inclut un faible rayon de courbure R. Grâce à ce faible rayon de courbure R, les trous borgnes 126 sont fragiles et forment facilement des fissures lorsque le substrat 104 est soumis à des contraintes, par exemple lors d'une attaque de la puce électronique 100 par amincissement depuis sa face arrière 102.

En outre, afin que ces trous borgnes 126 atteignent une profondeur importante dans le substrat 104, ou plus précisément une profondeur supérieure à celle qui serait obtenue en réalisant, pour une durée de gravure donnée, un trou borgne de section circulaire de rayon R, la forme de la section de chaque trou borgne 126, dans le plan parallèle à la face arrière 114 du substrat 104, est telle que sa surface S soit supérieure à la valeur π.R².

De manière avantageuse, la surface S de chaque trou borgne 126 est beaucoup plus grande que la celle de la section circulaire de rayon R, c'est-à-dire que la forme de la section de chaque trou borgne 126, dans le plan parallèle à la face arrière 114 du substrat 104, est telle que S >> π.R², ce qui permet d'avoir des trous borgnes 126 profond et très fragiles. Cela se vérifie lorsque la forme de la section de chacun des trous borgnes 126 est telle que la valeur du rapport S/(π.R²) est supérieure ou égale à environ 50, ou par exemple comprise entre environ 20 et 100, ou bien encore comprise entre environ 50 et 100, ou encore supérieure ou égale à environ 20.

La valeur du rayon de courbure R inclus dans le motif des contours des sections des trous borgnes 126 est choisie en fonction du niveau de fragilité que les trous borgnes 126 sont destinés à apporter à la structure de fragilisation, et par exemple comprise entre environ 1 µm et 10 µm.

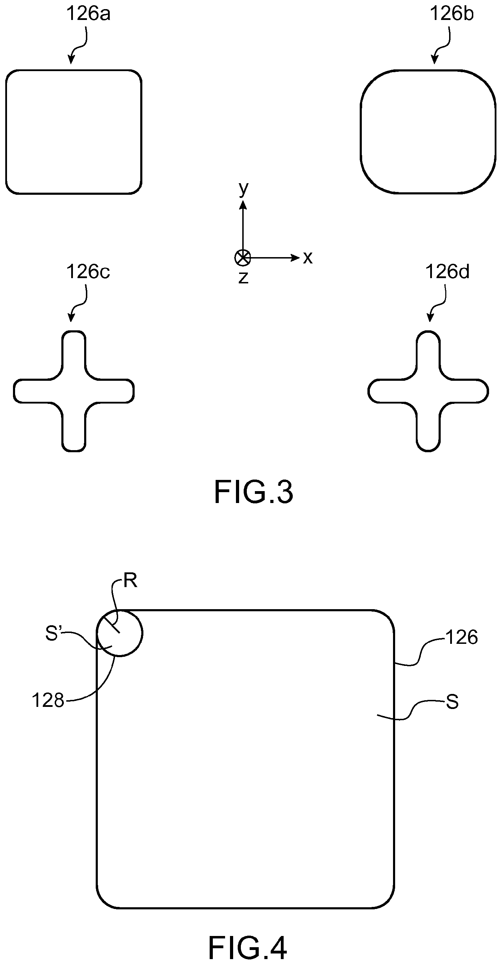

La figure 3 représente quatre exemples de réalisation de trous borgnes 126, référencés 126a, 126b, 126c et 126d, dont les sections, dans le plan parallèle à la face arrière 114 du substrat 104 (qui correspond au plan (X,Y) visible sur la figure 3), sont telles que leur motif inclut un rayon de courbure R et que leur surface S est telle que S > π.R². Sur cette figure, les sections des trous borgnes 126a et 126b ont une forme sensiblement carrée avec des coins arrondis. Le rayon de courbure R inclus dans le motif du contour extérieur fermé de chacun de ces trous borgnes 126a et 126b est formé par les coins arrondis des sections de ces trous borgnes 126a, 126b. En outre, on voit sur cette figure que le rayon de courbure des coins de la section du trou borgne 126a est plus petit que celui des coins de la section du trou borgne 126b. La fragilisation obtenue avec le trou borgne 126a est plus importante que celle obtenue avec le trou borgne 126b en raison de ce plus faible rayon de courbure induisant des contraintes plus importantes.

Sur l'exemple de la figure 3, les sections des trous borgnes 126a, 126b ont une forme sensiblement carrée à coins arrondis. Plus généralement, les sections des trous borgnes 126a, 126b peuvent avoir une forme sensiblement rectangulaire à coins arrondis.

D'autres formes de trous borgnes sont possibles. Selon un autre exemple, les trous borgnes 126c, 126d représentés sur la figure 3 ont une section, dans un plan parallèle à la face arrière 114 du substrat 104, en forme de croix comprenant des extrémités et/ou des jonctions des branches de la croix qui sont arrondies (sur la figure 3, les extrémités et les jonctions des branches de la croix sont arrondies) et qui présentent des rayons de courbure de valeur R et une surface S est telle que S > π.R².

De très nombreuses autres formes sont possibles et ne sont pas détaillées ici. Les rayons de courbure apportant la fragilité peuvent correspondre par exemple aux coins de la section des trous borgnes, et cela quelle que soit la forme et le nombre de coins arrondis de la section des trous borgnes.

Selon un exemple de réalisation, les trous borgnes 126 ont des sections de forme carrée avec des côtés de dimensions différentes d'un trou borgne à l'autre, et donc de surfaces différentes, mais avec des coins arrondis présentant tous le même rayon de courbure. On obtient ainsi une structure de fragilisation formée par des trous borgnes apportant chacun un même niveau de fragilisation (en raison du même rayon de courbure d'un trou borgne à l'autre) mais ayant des profondeurs différentes (en raison des surfaces différentes d'une section à l'autre).

Il est toutefois possible de réaliser la structure de fragilisation avec des trous borgnes 126 de même profondeur à travers le substrat 104, comme c'est le cas sur la figure 2.

La figure 4 représente un exemple de réalisation d'un trou borne 126 ayant une surface S et un contour extérieur fermé de forme carrée avec des coins arrondis, c'est-à-dire ici quatre parties courbées du contour ayant chacune un rayon de courbure R. Sur la figure 4, la référence 128 désigne un disque dont le rayon est égal au rayon de courbure R des coins du contour de la section du trou borgne 126. Le disque 128 a une surface S'=π.R². La figure 4 illustre bien que le fait que le trou borgne 126 a une section de surface S > S', et donc que S > π.R².

Dans la puce électronique 100, il est possible que tous les trous borgnes 126 formant la structure de fragilisation, ou qu'une partie seulement des trous borgnes de la structure de fragilisation, comporte une section telle que décrite ci-dessus, c'est-à-dire dont la forme du contour extérieur inclut au moins un rayon de courbure R tel que S > π.R², avec S correspondant à la surface de la section du trou borgne dans un plan parallèle à la face arrière du substrat 104.

Les trous borgnes 126 peuvent être remplis d'un matériau diélectrique, par exemple un polymère, et par exemple similaire à celui remplissant le volume restant des vias électriquement conducteurs 122 non occupé par du matériau électriquement conducteur, et par exemple le même matériau que celui formant la couche diélectrique 118.

De manière avantageuse, le matériau électriquement conducteur de la couche 121 est également déposé contre les parois latérales et les parois de fond des trous borgnes 126. Une telle couche électriquement conductrice porte la référence 123 sur la figure 2. En variante, il est possible que les parois des trous borgnes 126 soient recouvertes d'un matériau électriquement conducteur autre que celui servant à la métallisation des vias électriquement conducteurs 122.

Lorsque le substrat 104 comporte un semi-conducteur tel que du silicium, les faces avant et arrière 106, 114 du substrat 104 et les parois latérales des trous servant à la réalisation des vias électriquement conducteurs 122 et éventuellement celles des trous borgnes 126 sont recouvertes d'une couche diélectrique afin d'isoler électriquement le matériau électriquement conducteur disposé dans ces éléments vis-à-vis du semi-conducteur du substrat 104.

Pour réaliser la puce électronique 100, les étapes suivantes sont par exemples mises en œuvre :
Les composants formant la partie active du circuit électronique 108 sont tout d'abord réalisés au niveau de la face avant 106 du substrat 104 via la mise en œuvre d'étapes classiques de la microélectronique. Ces composants font partie de l'empilement de couches 110 qui forme la face avant 101 de la puce électronique 100. Cette face avant est solidarisée à une poignée temporaire formée par exemple par un substrat de semi-conducteur (par exemple de silicium) ou de verre, ce collage correspondant par exemple à un collage oxyde-oxyde lorsque la poignée temporaire comporte un semi-conducteur ou à un collage polymère lorsque la poignée temporaire comporte du verre.

Le substrat 104 est ensuite aminci depuis sa face arrière jusqu'à ce que l'ensemble formé du substrat 104 et du circuit électronique 108 ait l'épaisseur souhaitée, par exemple inférieure ou égale à environ 200 µm.

Un masque dur, comportant par exemple un oxyde, est ensuite réalisé sur la face arrière 114 du substrat 104. Le motif de ce masque définit le motif des trous destinés à la réalisation des vias électriquement conducteurs 122 ainsi que celui des trous borgnes 126. Les trous des futurs vias 122 et les trous borgnes 126 sont ensuite formés à travers le masque dur par gravure profonde du matériau du substrat 104.

Une couche diélectrique est ensuite déposée, par exemple par PECVD ou SACVD (dépôt chimique en phase vapeur à pression sub-atmosphérique), telle qu'elle recouvre le masque dur disposé sur la face arrière 114 du substrat 102, ainsi que les parois latérales et les parois de fond des trous des futurs vias électriquement conducteurs 122 et des trous borgnes 126. Les parties de cette couche diélectrique déposées sur les parois de fond des trous des futurs vias 122 sont ensuite supprimées afin que des contacts électriques puissent être ultérieurement réalisés avec les plots 124 par l'intermédiaire des vias 122 à travers le substrat 104. Si le circuit situé en face avant 106 nécessite que la couche électriquement conductrice située dans les trous borgnes 126 soit isolée électriquement du substrat 104, une étape supplémentaire de lithographie peut être insérée afin de protéger les trous borgnes 126 lors de l'étape de gravure de la couche isolante au fond des vias électriquement conducteurs 122.

La couche électriquement conductrice formant le matériau conducteur des vias 122 et celui déposé dans les trous borgnes 126 est ensuite réalisée par exemple par la mise en œuvre des étapes suivantes :
- dépôt d'une couche barrière à la diffusion, comportant par exemple un bicouche Ti/TiN (Ti déposé par exemple par PVD et TiN déposé par exemple par MOCVD, ou dépôt chimique en phase vapeur organométallique), sur la couche diélectrique déposée précédemment ainsi qu'au niveau des parois latérales et des parois de fond des trous des vias 122 et des trous borgnes 126 ;
- dépôt d'une couche de croissance, comportant par exemple du cuivre, sur la couche barrière ;
- lithographie d'un film sec (de type résine positive ou négative) de sorte à définir des régions d'isolation électrique entre différentes parties de la couche électriquement conductrice réalisée et croissance électrolytique, par exemple de cuivre, à partir de la couche de croissance dans les zones où celle-ci est dépourvue de motifs de résine ;
- retrait du film sec, puis gravure des parties de la couche de croissance et de la couche barrière au niveau des régions d'isolation entre les différentes parties de la couche électriquement conductrice (notamment entre les portions déposées dans les vias 122 et celles déposées dans les trous borgnes 126).

La couche diélectrique 118 est ensuite déposée, par exemple par un laminage sous vide, sur l'ensemble de la face arrière de la structure précédemment obtenue, c'est-à-dire sur et entre les portions de matériau électriquement conducteur précédemment réalisées dans les vias électriquement conducteurs 122 et dans les trous borgnes 126. Le matériau de la couche diélectrique 118 est par exemple également déposé tel qu'il remplisse les volumes vides restants des vias 122 et les trous borgnes 126. Ensuite, la couche de protection 118 est gravée (ou photo-définie si cette couche est à base de matériau photosensible) afin de former des ouvertures qui serviront à former les interconnexions électriques 125 reliant électriquement les vias électriquement conducteurs 122 aux extrémités de l'élément résistif 116.

L'élément résistif 116 est ensuite réalisé par exemple par la mise en œuvre des étapes suivantes :
- dépôt d'une couche barrière à la diffusion, comportant par exemple un bicouche Ti/TiN, sur la couche diélectrique 118 et dans les ouvertures ;
- dépôt d'une couche de croissance, comportant par exemple du cuivre, sur la couche barrière ;
- lithographie d'un film sec dont le motif (c'est-à-dire les endroits où la résine est retirée) correspond aux régions occupées par l'élément résistif 116 et croissance électrolytique, par exemple de cuivre, à partir de la couche de croissance ;
- retrait du film sec, puis gravure des parties de la couche de croissance et de la couche barrière au niveau des régions non occupées par l'élément résistif 116.

Selon un autre mode de réalisation, l'élément résistif 116 peut être réalisé par dépôt PVD d'un matériau électriquement conducteur, suivi d'une lithographie et d'une gravure.

La couche de protection 120 est ensuite déposée, par exemple via la mise en œuvre d'un dépôt à la tournette ou par laminage, encapsulant ainsi l'élément résistif 116 ainsi que les interconnexions électriques 125 et certaines parties de la couche diélectrique 118.

La poignée temporaire est ensuite retirée.

## Revendications

1. Puce électronique (100) comportant au moins :
- un circuit électronique (108) disposé du côté d'une face avant (106) d'un substrat (104) ;
- une structure de fragilisation permettant de fragiliser la puce en cas d'amincissement de celle-ci depuis sa face arrière, la structure de fragilisation comprenant au moins des trous borgnes (126, 126a-126d) traversant chacun une face arrière (114) du substrat (104) et une partie de l'épaisseur du substrat (104) et comportant chacun une section, dans un plan parallèle à la face arrière (114) du substrat (104), de surface S et ayant un contour extérieur fermé dont la forme inclut au moins un rayon de courbure R tel que S > π.R².

2. Puce électronique (100) selon la revendication 1, dans laquelle la forme du contour extérieur fermé de la section de chacun des trous borgnes (126, 126a-126d) est telle que la valeur du rapport S/(π.R²) est comprise entre environ 20 et 100, ou supérieure ou égale à 50.

3. Puce électronique (100) selon l'une des revendications précédentes, dans laquelle le contour extérieur fermé de la section de chacun des trous borgnes (126, 126a-126d), dans le plan parallèle à la face arrière (114) du substrat (104), est de forme sensiblement polygonale avec des coins arrondis de rayons de courbure de valeur R, et/ou est en forme de croix comprenant des extrémités et/ou des jonctions de branches de la croix qui sont arrondies et qui présentent des rayons de courbure de valeur R.

4. Puce électronique (100) selon l'une des revendications précédentes, dans laquelle les trous borgnes (126, 126a-126d) sont tels que les surfaces des sections desdits trous borgnes (126, 126a-126d) sont différentes les unes des autres et que les rayons de courbure inclus dans les formes des contours extérieurs fermés des sections desdits trous borgnes (126, 126a-126d) sont sensiblement similaires les uns des autres.

5. Puce électronique (100) selon l'une des revendications précédentes, dans laquelle des parois intérieures des trous borgnes (126, 126a-126d) sont recouvertes d'une couche électriquement conductrice (123).

6. Puce électronique (100) selon l'une des revendications précédentes, comportant en outre :
- au moins un élément résistif (116) disposé du côté de la face arrière (114) du substrat (104) et à l'aplomb d'au moins une partie du circuit électronique (108) ;
- au moins deux vias électriquement conducteurs (122) traversant le substrat (104) et s'étendant entre les faces avant et arrière (106, 114) du substrat (104), chacun relié électriquement au circuit électronique (108) et à l'une des extrémités de l'élément résistif (116) tel que la valeur de la résistance électrique de l'élément résistif (116) puisse être mesurée par le circuit électronique (108).

7. Puce électronique (100) selon la revendication 6, dans laquelle l'élément résistif (116) comporte au moins une piste électriquement conductrice ayant au moins un motif de serpentin et/ou plusieurs motifs alternés, entremêlés, enroulés ou entrelacés.

8. Procédé de réalisation d'une puce électronique (100) comportant au moins la mise en œuvre des étapes de :
- réalisation d'un circuit électronique (106) du côté d'une face avant (104) d'un substrat (102) ;
- réalisation d'une structure de fragilisation permettant de fragiliser la puce en cas d'amincissement de celle-ci depuis sa face arrière, la structure de fragilisation comprenant au moins des trous borgnes (126, 126a-126d) traversant chacun une face arrière (114) du substrat (104) et une partie de l'épaisseur du substrat (104) et comportant chacun une section, dans un plan parallèle à la face arrière (114) du substrat (104), de surface S et ayant un contour extérieur fermé dont la forme inclut au moins un rayon de courbure R tel que S > π.R².

9. Procédé selon la revendication 8, comportant en outre la réalisation d'un élément résistif (116) disposé du côté de la face arrière (114) du substrat (104) et à l'aplomb d'au moins une partie du circuit électronique (108), et d'au moins deux vias électriquement conducteurs (122) traversant le substrat (104) et s'étendant entre les faces avant et arrière (106, 114) du substrat (104), chacun relié électriquement au circuit électronique (108) et à l'une des extrémités de l'élément résistif (116) tel que la valeur de la résistance électrique de l'élément résistif (116) puisse être mesurée par le circuit électronique (108).

10. Procédé selon la revendication 9, dans lequel la réalisation des vias électriquement conducteurs (122) et des trous borgnes (126, 126a-126d) comporte au moins la mise en œuvre des étapes suivantes :
- réalisation d'un masque de gravure sur la face arrière (114) du substrat (104), dont le motif définit les sections, dans le plan parallèle à la face arrière (114) du substrat (104), des vias électriquement conducteurs (122) et des trous borgnes (126, 126a-126d) ;
- gravure à travers la face arrière (114) du substrat (104) selon le motif du masque de gravure.

## Patentansprüche

1. Elektronischer Chip (100), umfassend wenigstens:
- eine elektronische Schaltung (108), die an der Seite einer Vorderseite (106) eines Substrats (104) angeordnet ist;
- eine Schwächungsstruktur, die es ermöglicht, den Chip zu schwächen, wenn er von seiner Rückseite her dünner wird, wobei die Schwächungsstruktur wenigstens Sacklöcher (126, 126a-126d) umfasst, die jeweils durch eine Rückseite (114) des Substrats (104) und einen Teil der Dicke des Substrats (104) verlaufen und jeweils einen Abschnitt in einer Ebene parallel zur Rückseite (114) des Substrats (104) mit der Fläche S und einer geschlossenen Außenkontur aufweisen, deren Form wenigstens einen Krümmungsradius R umfasst, so dass S > π.R².

2. Elektronischer Chip (100) nach Anspruch 1, wobei die Form der geschlossenen Außenkontur des Abschnitts jedes der Sacklöcher (126, 126a-126d) derart beschaffen ist, dass der Wert des Verhältnisses S/(π.R²) zwischen etwa 20 und 100 liegt oder größer oder gleich 50 ist.

3. Elektronischer Chip (100) nach einem der vorhergehenden Ansprüche, wobei die geschlossene Außenkontur des Abschnitts jedes der Sacklöcher (126, 126a-126d) in der Ebene parallel zur Rückseite (114) des Substrats (104) im Wesentlichen polygonal mit abgerundeten Ecken mit Krümmungsradien des Wertes R und/oder kreuzförmig mit abgerundeten Enden und/oder Verbindungen von Kreuzarmen, die abgerundet sind und die Krümmungsradien mit dem Wert R aufweisen.

4. Elektronischer Chip (100) nach einem der vorhergehenden Ansprüche, wobei die Sacklöcher (126, 126a-126d) derart sind, dass die Oberflächen der Abschnitte der Sacklöcher (126, 126a-126d) voneinander verschieden sind und dass die Krümmungsradien, die in den Formen der geschlossene Außenkonturen der Abschnitte der Sacklöcher (126, 126a-126d) enthalten sind, einander im Wesentlichen ähnlich sind.

5. Elektronischer Chip (100) nach einem der vorhergehenden Ansprüche, wobei die Innenwände der Sacklöcher (126, 126a-126d) mit einer elektrisch leitenden Schicht (123) bedeckt sind.

6. Elektronischer Chip (100) nach einem der vorhergehenden Ansprüche, ferner umfassend:
- wenigstens ein Widerstandselement (116), das auf der Seite der Rückseite (114) des Substrats (104) und lotrecht zu wenigstens einem Teil der elektronischen Schaltung (108) angeordnet ist;
- wenigstens zwei elektrisch leitende Verbindungen (122), die durch das Substrat (104) verlaufen und sich zwischen der Vorder- und der Rückseite (106, 114) des Substrats (104) erstrecken, wobei jede elektrisch mit der elektronischen Schaltung (108) und mit einem der Enden des Widerstandselements (116) verbunden ist, so dass der Wert des elektrischen Widerstands des Widerstandselements (116) von der elektronischen Schaltung (108) gemessen werden kann.

7. Elektronischer Chip (100) nach Anspruch 6, wobei das Widerstandselement (116) wenigstens eine elektrisch leitende Spur mit wenigstens einem Serpentinenmuster und/oder mehreren abwechselnden, ineinandergreifenden, gewickelten oder verschachtelten Mustern aufweist.

8. Verfahren zur Herstellung eines elektronischen Chips (100), welches wenigstens die Durchführung der folgenden Schritte umfasst:
- Herstellen einer elektronischen Schaltung (106) auf der Seite einer Vorderseite (104) eines Substrats (102);
- Herstellen einer Schwächungsstruktur, die es ermöglicht, den Chip zu schwächen, wenn er von seiner Rückseite her dünner wird, wobei die Schwächungsstruktur wenigstens Sacklöcher (126, 126a-126d) umfasst, die jeweils durch eine Rückseite (114) des Substrats (104) und einen Teil der Dicke des Substrats (104) verlaufen und jeweils einen Abschnitt in einer Ebene parallel zur Rückseite (114) des Substrats (104) mit der Fläche S und einer geschlossenen Außenkontur aufweisen, deren Form wenigstens einen Krümmungsradius R umfasst, so dass S > π.R².

9. Verfahren nach Anspruch 8, ferner umfassend die Herstellung eines Widerstandselements (116), das auf der Seite der Rückseite (114) des Substrats (104) und lotrecht zu wenigstens einem Teil der elektronischen Schaltung (108) angeordnet wird, und von wenigstens zwei elektrisch leitenden Verbindungen (122), die durch das Substrat (104) verlaufen und sich zwischen der Vorder- und der Rückseite (106, 114) des Substrats (104) erstrecken, die jeweils elektrisch mit der elektronischen Schaltung (108) und mit einem der Enden des Widerstandselements (116) verbunden sind, so dass der Wert des elektrischen Widerstands des Widerstandselements (116) durch die elektronische Schaltung (108) gemessen werden kann.

10. Verfahren nach Anspruch 9, wobei die Herstellung der elektrisch leitenden Verbindungen (122) und der Sacklöcher (126, 126a-126d) wenigstens die Durchführung der folgenden Schritte umfasst:
- Herstellen einer Ätzmaske auf der Rückseite (114) des Substrats (104), deren Muster die Abschnitte der elektrisch leitenden Verbindungen (122) und der Sacklöcher (126, 126a-126d) in der Ebene parallel zur Rückseite (114) des Substrats (104) definiert;
- Ätzen durch die Rückseite (114) des Substrats (104) gemäß dem Muster der Ätzmaske.

## Claims

1. Electronic chip (100) including at least:
- an electronic circuit (108) disposed on the side of a front face (106) of a substrate (104);
- an embrittlement structure enabling to weaken the chip if the chip is thinned from its rear face, the embrittlement structure comprising at least blind holes (126, 126a-126d) each extending through a rear face (114) of the substrate (104) and a part of the thickness of the substrate (104) and each including a cross-section, in a plane parallel with the rear face (114) of the substrate (104), of surface area S and having a closed outer contour the shape whereof includes at least one radius of curvature R such that S > π.R².

2. Electronic chip (100) according to claim 1, wherein the shape of the closed outer contour of the cross-section of each of the blind holes (126, 126a-126d) is such that the value of the ratio S/(π.R²) is between about 20 and 100, or greater than or equal to 50.

3. Electronic chip (100) according to one of the preceding claims, wherein the closed outer contour of the cross-section of each of the blind holes (126, 126a-126d), in the plan parallel with the rear face (114) of the substrate (104), is of substantially polygonal shape with rounded corners of radii of curvature of value R, and/or is cross-shaped comprising ends and/or junctions of arms of the cross which are rounded and which have radii of curvature of value R.

4. Electronic chip (100) according to one of the preceding claims, wherein the blind holes (126, 126a-126d) are such that the surfaces of the cross-sections of said blind holes (126, 126a-126d) are different from one another and that the radii of curvature included in the shapes of the closed outer contours of the cross-sections of said blind holes (126, 126a-126d) are substantially similar to one another.

5. Electronic chip (100) according to one of the preceding claims, wherein inner walls of the blind holes (126, 126a-126d) are covered with an electrically conductive layer (123).

6. Electronic chip (100) according to one of the preceding claims, further including:
- at least one resistive element (116) disposed on the side of the rear face (114) of the substrate (104) and plumb with at least a part of the electronic circuit (108);
- at least two electrically conductive vias (122) extending through the substrate (104) and extending between the front and rear faces (106, 114) of the substrate (104), each electrically connected to the electronic circuit (108) and to one of the ends of the resistive element (116) such that the value of the electrical resistance of the resistive element (116) can be measured by the electronic circuit (108).

7. Electronic chip (100) according to claim 6, wherein the resistive element (116) includes at least one electrically conductive track having at least one coil pattern and/or several alternating, interlocked, wound, or interlaced patterns.

8. Method for producing an electronic chip (100) including at least the execution of the steps of:
- producing an electronic circuit (106) on the side of a front face (104) of a substrate (102);
- producing an embrittlement structure enabling to weaken the chip if the chip is thinned from its rear face, the embrittlement structure comprising at least blind holes (126, 126a-126d) each extending through a rear face (114) of the substrate (104) and a part of the thickness of the substrate (104) and each including a cross-section, in a plane parallel with the rear face (114) of the substrate (104), of surface area S and having a closed outer contour the shape whereof includes at least one radius of curvature R such that S > π.R².

9. Method according to claim 8, further including the production of a resistive element (116) disposed on the side of the rear face (114) of the substrate (104) and plumb with at least a part of the electronic circuit (108), and of at least two electrically conductive vias (122) extending through the substrate (104) and extending between the front and rear faces (106, 114) of the substrate (104), each electrically connected to the electronic circuit (108) and to one of the ends of the resistive element (116) such that the value of the electrical resistance of the resistive element (116) can be measured by the electronic circuit (108).

10. Method according to claim 9, wherein the production of the electrically conductive vias (122) and the blind holes (126, 126a-126d) includes at least the execution of the following steps:
- producing an etching mask on the rear face (114) of the substrate (104), the pattern whereof defines the cross-sections, in the plane parallel with the rear face (114) of the substrate (104), of the electrically conductive vias (122) and the blind holes (126, 126a-126d);
- etching through the rear face (114) of the substrate (104) according to the pattern of the etching mask.
